# EUROPEAN PATENT SPECIFICATION

(11) **EP 3 382 737 B1**
(45) Date of publication and mention of the grant of the patent: **20.11.2019**
(21) Application number: 18170399.2
(22) Date of filing: 19.10.2015
(51) Int. Cl.: H01J 37/32, C23C 16/448, H01J 37/34

(54) **PLASMA PROCESS AND REACTOR FOR THE THERMOCHEMICAL TREATMENT OF THE SURFACE OF METALLIC PIECES**
PLASMAVERFAHREN UND REAKTOR ZUR THERMOCHEMISCHEN BEHANDLUNG DER OBERFLÄCHE VON METALLISCHEN TEILEN
TRAITEMENT ET RÉACTEUR À PLASMA POUR LE TRAITEMENT THERMOCHIMIQUE DE LA SURFACE DE PIÈCES MÉTALLIQUES

(30) Priority: 20.10.2014 BR 102014026134
(43) Date of publication of application: 03.10.2018
(62) Divisional of application: 15790820.3
(73) Proprietor: Universidade Federal De Santa Catarina (UFSC), 88040-900 Florianópolis - SC (BR)
(72) Inventor: BINDER, Cristiano, 88040-670 Florianópolis (BR); BERNARDELLI, Euclides Alexandre, 83326-560 Pinhais (BR); HAMMES, Gisele, 88040-670 Florianópolis (BR); KLEIN, Aloisio Nelmo, 88037-620 Florianópolis (BR); LAMIM, Thiago De Souza, 88132-738 Palhoça (BR); BINDER, Roberto, 89220-730 Joinville (BR)
(74) Representative: Soldatini, Andrea

(56) References cited:
- WO-A1-99/22043
- WO-A1-2009/149526
- US-A- 4 490 190

## Description

### Field of the Invention

The present invention refers to a process and to a multifunctional plasma reactor for carrying out the surface thermochemical treatment of metallic pieces, aiming to introduce chemical elements into the pieces to be treated or to form a surface layer of composites or combinations of chemical elements connected to each other, in order to provide said pieces with a greater mechanical strength and/or resistance to corrosion/wear. The plasma reactor of the invention allows different treatment operations to be carried out, including cleaning, nitriding and other surface treatments with chemical precursors that require cracking and/or sputtering, in order to be applied over the metallic pieces under treatment.

### Background of the Invention

In many of the industrial applications, in order for a material to be suitable for certain requirements, it is only necessary to modify its surface properties. The treatments more commonly used are nitriding, carburizing, carbonitriding and others.

Among the existing processes for carrying out such treatments, the one carried out by plasma presents some advantages in relation to the others, which may be defined as: short treatment time; low process temperature; less pollution; and greater uniformity of the surface layer formed in the piece.

One of the disadvantages of such processes is the introduction of alloy elements which, in their natural phase, are not in the form of a gas, such as the case of molybdenum, silicon, chrome, nickel and others. In such cases, the surface treatment used is carried out by sputtering the alloy element to be deposited on the piece or by heating a filament of said alloy element until it progressively vaporizes into the gas phase.

Another known way of providing a surface treatment of metallic pieces by alloy elements includes using a liquid precursor containing the desired alloy element, such as the hexamethyldisiloxane, molybdic acid and others, such precursors usually presenting long chains which require being submitted to cracking so that the alloy element existing in the precursor is separated and conducted to the piece to be treated.

For carrying out the enrichment process by alloy elements, some types of plasma rectors have been developed by several authors.

An example of a plasma process and reactor for treating metallic pieces is disclosed in WO 2009/149526 A1.

### Sputtering Reactors

In the cases in which the desired alloy element is only available in solid phase precursors, it is commonly used the sputtering in the interior of the plasma reactor, in order to obtain the release of the desired alloy element and its subsequent conduction to the piece to be treated.

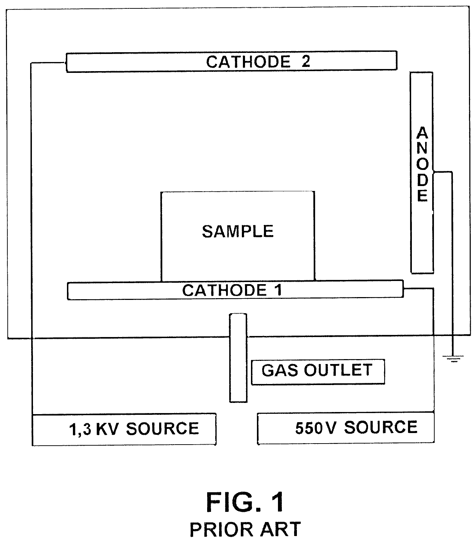

The reactor used by Liu *et al* (Xiaopinga, L., Yuanb, G., Zhonghoub, L., Zhongb, X., Wenhuaia, T., Binb, T. Cr-Ni-Mo-Co surface alloying layer formed by plasma surface alloying in pure iron. Applied Surface Science, v. 252, p. 3894-3902, 2006) comprises two energy sources (see Figure 1), with the pieces to be treated being negatively polarized from -530V to -580V (cathode 1) and the material (target) subjected to the sputtering process being polarized from 1.3 a 1.35kV (cathode 2) .

With this invention, Liu may attract more effectively the atoms pulverized from the cathode 2, due to the polarization of the pieces (samples) in cathode 1, thus increasing the process efficiency and assuring greater uniformity in the surface treatment of the pieces.

In this solution proposed by Liu, the surfaces to be treated may be placed vertically in relation to the cathode 2 and still be treated efficiently. Liu aimed to increase the process efficiency, since the atoms would no longer reach the surface only by diffusion, but would be accelerated due to the presence of the negative potential of the cathode 2 on the surface of the pieces to be treated.

Despite the advantages of using sputtering of solid precursors together with the negative polarization of the pieces to be treated in a cathode other than the one of the sputtering, the solution proposed by Liu does not allow carrying out thermochemical treatments which demand an alloy element found in liquid or gas precursors which present long chains which are required to be cracked for separating the alloy elements before depositing the latter over the surfaces of the pieces. Furthermore, Liu does not suggest any particular constructive arrangement which promotes a greater energy efficiency for the sputtering.

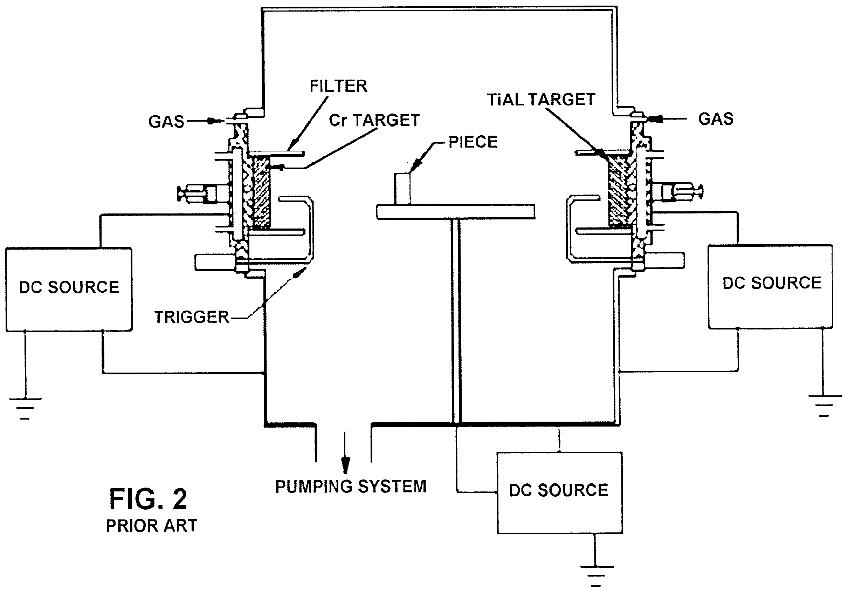

Another known solution for the thermochemical treatment in a plasma reactor is presented in the work of Chang et al (Chi-Lung Chang, Jui-Yun Jao, Wei-Yu Ho, Da-Yung Wang. Influence of bi-layer period thickness on the residual stress, mechanical and tribological properties of nanolayered TiAlN/CrN multi-layer coatings. Vacuum 81 (2007) 604-609). The reactor used in this solution presents three energy sources to carry out the treatment (see figure 2). This solution uses the cathodic arc pulverization of a first precursor (target) of TiAl and of a second precursor (target) of Cr. The piece is positioned in the second cathode, in order to be reached by the atoms of TiSi and Cr diffused in the gas phase. Nitrogen gas is used to react with the chemical elements Al e Ti, in order to form, in the surface of the material to be treated, a TiAlN/CrN film.

The process in Chang is different from the process in Liu, since Chang uses three sources in the same reactor. In this case, one source is provided to obtain chrome, the other is provided to obtain TiAl and the last source is used to polarize the samples (pieces to be treated).

Although using polarization of the pieces with a third high voltage energy source, the Chang solution uses a cathodic arc to achieve vaporization of the different alloy elements of interest, associated with the first and with the second high voltage source. However, the use of the voltaic arc in the reactor environment in order to obtain the sputtering causes high temperatures close to the pieces to be treated, jeopardizing the characteristics of these pieces which have already been subjected to previous thermal treatments.

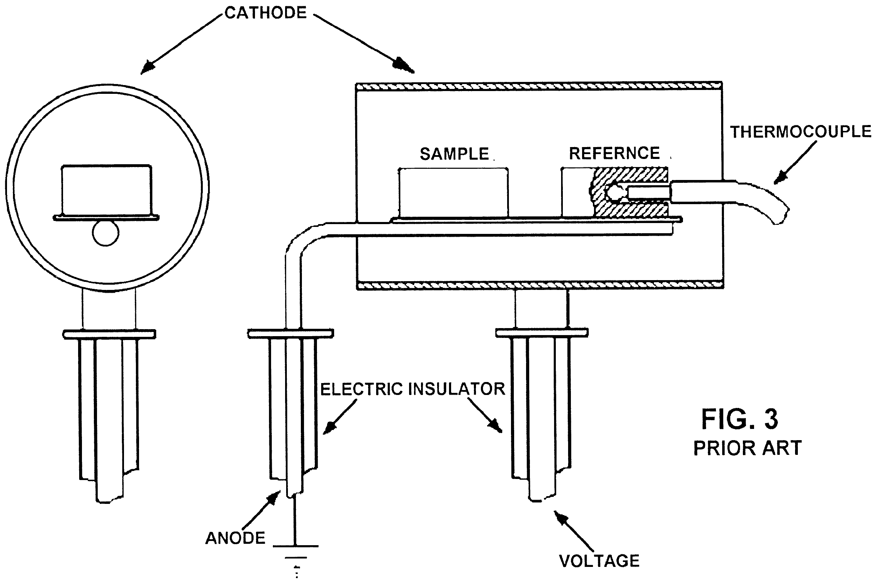

Still another known solution is described by Pavanati et al (Pavanati, H.C., Lourenc, J.M., Maliska, A.M., Klein, A.N., Muzart, J.L.R. Ferrite stabilization induced by molybdenum enrichment in the surface of unalloyed iron sintered in an abnormal glow discharge. Applied Surface Science, v. 253, p. 9105-9111, 2007). This solution uses a metallic target as a source of alloy element and the material to be enriched is positioned in the anode (see figure 3). The problem in the solution proposed by Pavanati is the lack of polarization in the surfaces to be treated, thus reducing the process efficiency. Only the surface parallel to the target of sputtering will be treated with increased efficiency, if it is not provided the continuous rotation of the pieces during treatment, and that is not even suggested by Pavanati.

Still in relation to the reactors using a single source for the plasma generation, there is the experimental device used by Brunato et al (Brunato, S.F., Klein, A. N., Muzart, J.L.R. Hollow Cathode Discharge: Application of a Deposition Treatment in the Iron Sintering. Journal of the Brazil Society of Mechanical Science & Engineering., p.147. 2008) .

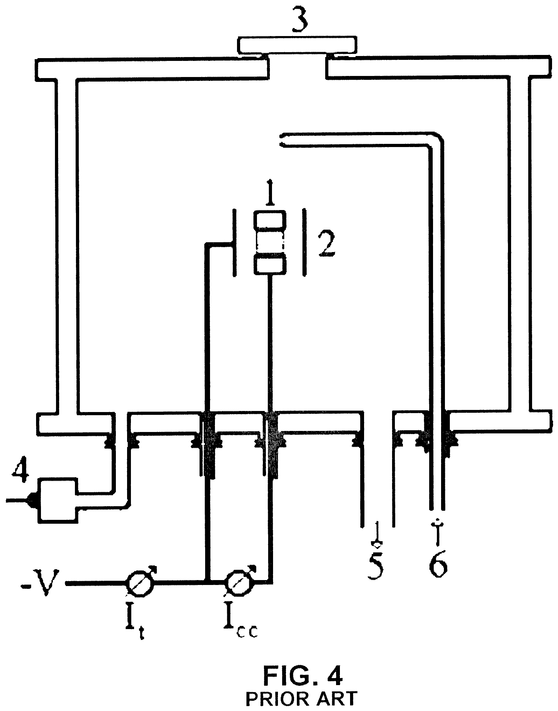

In order to increase the sputtering rate, Brunato uses the hollow cathode expedient, with the samples being positioned therein (see figure 4).

In Brunato case, the samples are positioned inside the hollow cathode. Although the sputtering in a hollow cathode allows for an increase in process efficiency, the Brunato solution presents the drawback of limiting the size of the samples, since the dimensions for obtaining the hollow cathode are reduced. Furthermore, the pieces to be treated are subjected to high temperatures resulting from the discharge in hollow cathode.

In the reactors using the sputtering process to supply the desired alloy element in the treatment environment without subjecting the pieces to be treated to a negative polarization, the uniformity of the layer is only achieved if the piece is rotated during processing, thus allowing the entire surface of a certain piece to be close to the alloy element source. Such characteristic is a drawback for treating a large batch of pieces.

Even in the cases in which the sputtering is used together with the polarization of the pieces, such as is the case in the Liu solution, the drawback of limiting the thermochemical treatment to the use of alloy elements provided in solid precursors is still present, not allowing the simultaneous or consecutive treatment of the pieces, without moving the latter, by deposition of alloy elements which require liquid precursors and/or which present long chains.

### Reactors using liquid precursors

In the cases in which the alloy element or the chemical element required for forming the desired compound is only available in precursors in the liquid or gas phase and which present long chains, it is commonly used cracking in the interior of the plasma reactor for obtaining the release of the desired alloy element and the subsequent deposition thereof on the piece to be treated. In relation to the works using liquid precursors as carriers of the alloy elements, there can be mentioned the works of Aumaille et al (Aumaille, K., Valleae, C., Granier, A., Goullet, A. Gaboriau, F. Turban, G. A comparative study of oxygen/organosilicon plasmas and thin SiOxCyHz lms deposited in a helicon reactor Thin Solid Films, v. 359, p. 188-196, 2000).

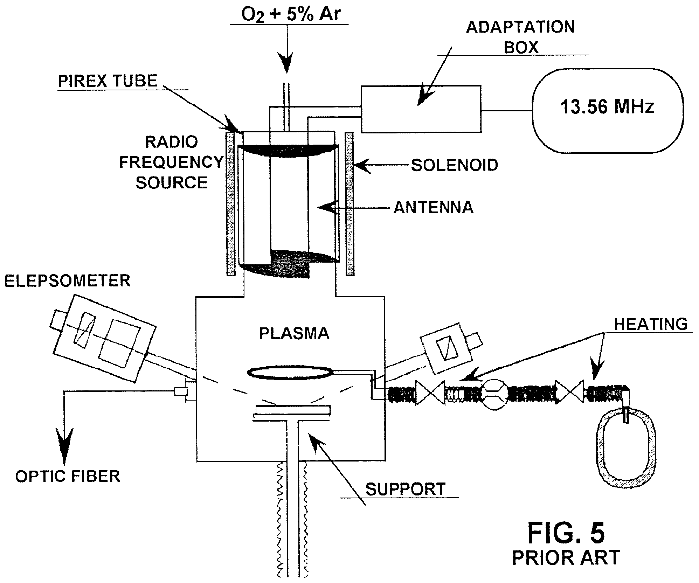

In this prior solution (figure 5) it is used a radiofrequency source ("*helicon source*") in order to generate the plasma, with the samples being positioned in a grounded sample holder, preventing the pieces to be treated from being polarized and thus subjected to a bombardment by ions or accelerated electrons. In this case, in order to obtain an efficiency in the process of treatment and homogenization in the formation of the surface layer or layers on the pieces, the latter must be rotated inside the reactor so that the different faces thereof face the alloy element source. In this solution, the liquid precursor is not directly cracked during discharge, but submitted to cracking after discharge.

There are plasma reactors with a radiofrequency source in which it is possible to carry out the cracking of the liquid precursor directly on the surface of the material to be treated. In these cases, the samples are polarized. Further, there are radiofrequency reactors in which the cracking of the precursor takes place at a region far away from the sample, and in such case the samples are grounded. In this last case, the chemical elements which will take place in the surface treatment may be better selected, but the chemical elements are not efficiently attracted.

In another known solution, the reactor presents a pulsating DC power supply in order to polarize the samples, using liquid precursors as carriers of the alloy element. The pieces are positioned in the cathode, with the precursor being cracked on the surface of the material to be treated. This impairs the selection of the elements which will take place in the treatment, since all the elements of the liquid precursor, normally being the oxygen, the carbon, the hydrogen, the silicon, the molybdenum or others will be part of the enriched layer.

The fact is that the cracking on the surface of the pieces to be treated does not allow for a selective surface treatment, since all the elements comprised in the precursor will be part of the layer deposited over the pieces being treated.

It is also known the cracking of the precursor in the inner atmosphere of the reactor and the deposition of the alloy element on the surface of the pieces to be treated using a microwave source. In this case, the reactor of Bapin et al, not illustrated, (Bapin, E., Rohr, R. Deposition of SiO2 films from different organosiliconO2 plasmas under continuous wave and pulsed modes. Surface and Coatings Technology, v.142-144, p. 649-654, 2001) uses a microwave source in order to generate the plasma and to crack the liquid precursors named organosilicon, with the objective of obtaining a film of SiO₂ deposited on the surface of the material to be treated.

In the reactors with a microwave source, the pieces are positioned under a fluctuating potential. In this case, the layer is formed by the elements resulting from the cracking carried out by the microwave discharge. Thus, the chemical elements are not attracted by the material of the piece to be treated, however are deposited over the latter. This makes difficult the formation of an enriched layer, reducing the process efficiency, since it is not provided the ion or electron bombardment as a result of the polarization of the pieces under treatment.

Even in the cases in which the cracking by a DC source or by radiofrequency, or by microwave is present, the drawback of not having the polarization of the pieces impairs the efficiency and the uniformity of the deposition process, since there is no ion bombardment of the cracked alloy elements on the surfaces of the pieces which are not suitably positioned in relation to the source of the cracked material. The displacement of the pieces in such solutions presents a highly undesirable complexity.

On the other hand, the reactors that present sample polarization and do not comprise a cracking system of the liquid precursor, present the drawback of having a reduced capacity of selecting the desired chemical element.

### Summary of the invention

One objective of the present invention is to provide a process and a reactor for the uniform surface thermochemical treatment, by a gas plasma, of all the surfaces of metallic pieces statically positioned inside a reactor, from alloy elements obtained at high temperature by cracking of at least one long chain liquid or gas precursor, without modifying the temperature of the metallic pieces and without leading to the formation of electric arcs in the inner environment of the reactor.

Another objective of the invention is to provide a process and a reactor for the uniform surface thermochemical treatment, by a gas plasma, of all the surfaces of metallic pieces statically positioned inside a reactor, from alloy elements obtained at high temperature by sputtering of at least one solid precursor, without modifying the temperature of the metallic pieces and without leading to the formation of electric arcs in the inner environment of the reactor.

One further objective of the invention is to provide a process and a reactor for the surface treatment of metallic pieces which serves, selectively or simultaneously, both objectives mentioned above.

In a summarized way, the invention proposed herein uses a reactor with a reaction chamber which, being heated to a desired operational temperature during the surface treatment, is provided with a support carrying the pieces to be treated and which defines an electrode of an anode and cathode system, which is negatively polarized from a high voltage pulsating DC power supply, the other electrode of this system being positioned inside the reactor and defining the grounded anode of said system.

In a way of carrying out the process or reactor invention, the latter is provided with a tubular cracking chamber, operatively associated with the reaction chamber and in which is admitted a flow of a liquid or gas precursor, with the tubular cracking chamber further being electrically connected to a high voltage energy source, in order to allow a potential difference to be applied between the tubular cracking chamber and the anode and cathode system for dissociating the molecules of the precursor, releasing, to the interior of the reaction chamber, the alloy elements to be ionically bombarded against the surfaces of the metallic pieces negatively polarized by the pulsating DC power supply.

The invention thus allows a certain batch of pieces to have surface treatment inside the same reactor, from long chain liquid or gas precursors, to be cracked in a tubular cracking chamber open to the interior of the reaction chamber.

### Description of the drawings

The invention will be described below, with reference to the enclosed drawings, given by way of example, in which:

Figure 1 represents a prior art process and reactor solution, which provides exclusively the sputtering together with the polarization of the pieces inside the reaction chamber, with the sputtering being carried out directly in the inner environment of the reaction chamber;

Figure 2 represents another prior art process and reactor solution, which provides only the sputtering by a cathodic voltaic arc from a first and a second solid precursor in two separate cathodes, inside the environment of the reaction chamber, causing high temperatures close to the pieces;

Figure 3 represents another prior art process and reactor solution, which provides a metallic target as a source of alloy element to be obtained only by sputtering, with the material to be enriched being positioned in the anode, however not providing the polarization on the surfaces of the pieces under treatment;

Figure 4 represents another prior art process and reactor solution which provides only the hollow cathode sputtering, with the samples being dimensioned to be mandatorily positioned in the interior of the hollow cathode having mandatorily limited dimensions;

Figure 5 represents another prior art process and reactor solution using liquid precursors as carriers of the alloy element, and a radiofrequency source ("*helicon source*") to generate the plasma, with the not polarized samples being positioned in a grounded sample holder;

Figure 6 schematically represents a plasma reactor built according to a first heating embodiment and with the reaction chamber thereof housing a support on which are statically supported some metallic pieces, this type of reactor being used for treatments under temperatures from 100°C to 1300°C; and

Figure 7 schematically represents the plasma reactor of Figure 6, built according to a second heating embodiment of the reaction chamber, in order to be used for treatments under temperatures from 100°C to 1000°C.

### Description of the Invention

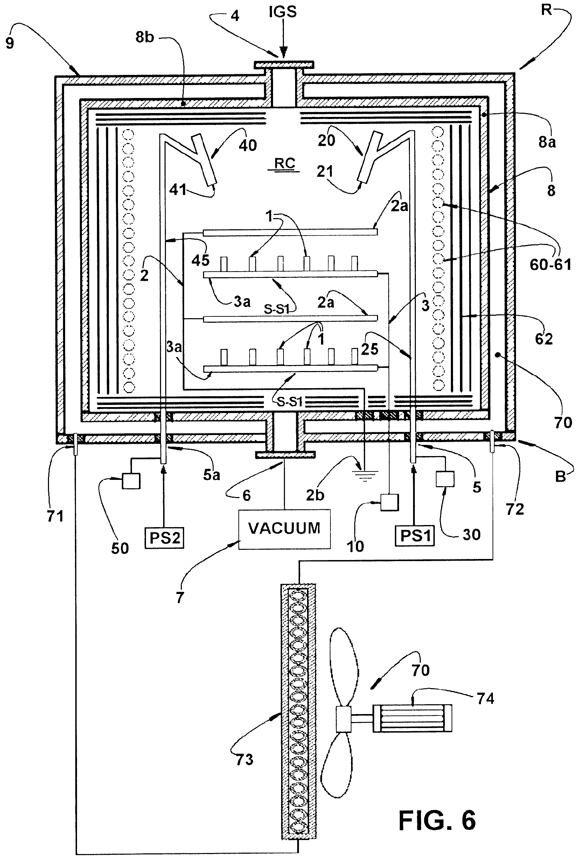

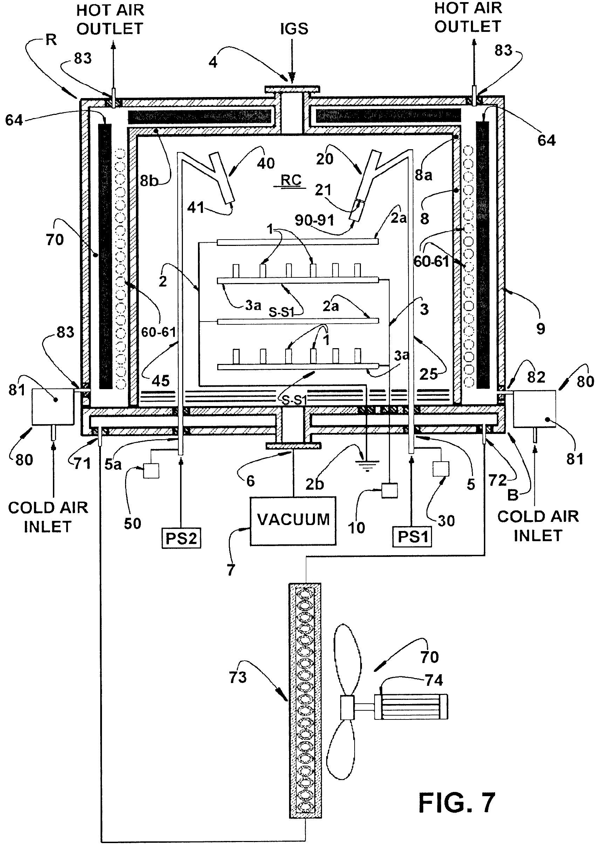

As mentioned above and illustrated in the attached drawings (figures 6 and 7), the invention comprises, according to one of its aspects, a process for the thermochemical treatment of the surface of metallic pieces 1, to be carried out in a plasma reactor R of the type presenting a reaction chamber RC inside which is provided a support S carrying the metallic pieces 1; a system of anode 2 and cathode 3 with one of its electrodes 2a, 3a associated with a high voltage pulsating DC power supply 10; an inlet 4 of ionizable gas load; an inlet 5 of liquid or gas precursor; and an outlet 6 for exhaustion of gas load, usually connected to a vacuum assembly 7.

Constructive details of the reactor used in the present invention will be discussed further below with reference to figures 6 and 7.

According to a first aspect of the invention, the treatment process comprises the steps of:
a) connecting the anode 2 to a first electrode 2a and to a ground 2b and connecting the cathode 3 to the support S, operating as the other electrode 3a of the system of anode 2 e cathode 3, and to a negative potential of the high voltage pulsating DC power supply 10;
b) statically positioning the metallic pieces 1 on the support S-S1 associated with the cathode 3 in the interior of the reaction chamber RC;
c) surrounding the support S and the metallic pieces 1 with a ionizable gas load fed to the reaction chamber RC through the inlet 4;
d) heating the interior of the reaction chamber RC to a given working temperature;
e) applying to the cathode 3, associated with the support S and with the metallic pieces 1, an electric discharge, in order to provoke the formation of a ion gas plasma having high kinetic energy surrounding the metallic pieces 1 and the support S;
f) admitting a flow of liquid precursor (for example, the hexamethyldisiloxane (C₆H₁₈OSi₂)), or gas precursor, in a tubular cracking chamber 20 which is preferably subjected to the working temperature inside the reaction chamber RC of the reactor R, said tubular cracking chamber 20 having at least one end 21 open to the interior of the reaction chamber RC and being associated with a high voltage energy source 30;
g) applying a potential difference between the tubular cracking chamber 20 and the anode 2 of the system of anode 2 and cathode 3 for dissociating the molecules of the precursor, thus releasing, to the interior of the reaction chamber RC, the alloy elements to be ionically bombarded against the surfaces of the metallic pieces 1 negatively polarized by the pulsating DC power supply 10; and
h) providing the exhaustion of the gas load from the interior of the reaction chamber RC.

Particularly, the tubular cracking chamber 20 is built, for example, in the form of a cup with an end open to the interior of the reaction chamber RC, or in the form of a tube, with both ends open to the interior of the reaction chamber RC, in order to define a hollow cathode in association with the anode 2 of the system of anode 2 and cathode 3 of the reaction chamber RC of the reactor R.

The formation of the hollow cathode defined by the tubular chamber 20 should observe the relation between the diameter (d) of the tube of the tubular chamber and the working pressure (p), according to the equation d.p = 0.375 to 3.75. The closer to the minimum the result of the equation, the more efficient will be the cracking of the liquid precursor. The same principle for forming the hollow cathode may be applied to the sputtering of the solid precursor.

The ionizable gas load may further comprise the addition of a gas selected among oxygen, hydrogen, nitrogen, methane, acetylene, ammonia, carbon dioxide, carbon monoxide and argon, in order to react with the atoms or molecules obtained by cracking of the liquid precursor, thus forming compounds directed to the metallic pieces 1 having a kinetic energy equal to the potential difference applied to the system of anode 2 and cathode 3. The ionization of the gas load and of the liquid precursor may be carried out by DC electric discharge under a low pressure atmosphere, generating plasma and producing the alloy elements or compound for the surface treatment of the metallic pieces 1.

The process steps mentioned above allow the surface treatment to be carried out solely by cathodic cracking of liquid or gas precursors presenting long chains which need to be broken, in order for the desired alloy elements to be ionically bombarded against the surface of the metallic pieces 1 suitably polarized. This aspect of the invention uses the cracking of the precursor in a separate environment, however open to the interior of the reaction chamber RC, together with the negative polarization of the metallic pieces 1 under treatment. The temperature used to carry out the cracking is independent of the temperature for treating the pieces, making possible to form compounds at high temperature with subsequent deposition on the surface to be treated.

However, the thermochemical treatment of the surface of the metallic pieces inside the reactor may further comprise only one treatment, by sputtering of a solid precursor, or the treatment by cracking of the liquid or gas precursor, carried out after, subsequently, together or also before the treatment by sputtering of the precursor.

Thus, depending on the treatment to be carried out and on the characteristics of the precursors available for providing the desired alloy elements inside the reaction chamber, the present process allows providing, together with the respective reactor, a great flexibility in the treatment process, without requiring the displacement of the metallic pieces among different pieces of equipment in order to be subjected to different phases of the desired surface treatment.

Thus, the invention may further comprise, independently or together with the cracking process of the liquid or gas precursor, a treatment process further comprising, before, during or after the steps of the thermochemical treatment of the surface by cracking of the precursor, the steps of:
a') if not already previously carried out, connecting the anode 2 to a first electrode 2a and to a ground 2b and connecting the cathode 3 to the support S, operating as the other electrode 3a of the system of anode 2 and cathode 3, and to a negative potential of the pulsating DC power supply 10;
b') if not already previously carried out, statically positioning the metallic pieces 1 on the support S associated with the cathode 3 inside the reaction chamber RC;
c') surrounding the support S and the metallic pieces 1 with an ionizable gas load fed to the reaction chamber RC through the inlet 4;
d') heating the interior of the reaction chamber RC to a given working temperature;
e') applying to the cathode 3, associated with the support S and with the metallic pieces 1, an electric discharge in order to cause the formation of a ion gas plasma, having high kinetic energy, surrounding the metallic pieces 1 and the support S;
f') providing a solid precursor PS2 defining the interior of a tubular sputtering chamber 40, preferably subjected to the working temperature in the interior of the reaction chamber RC of the reactor R, said tubular sputtering chamber 40 having at least one end 41 open to the interior da reaction chamber RC and being associated with an electric power supply 50;
g') applying a potential difference between the tubular sputtering chamber 40 and the anode 2 of the system of anode 2 and cathode 3 in order to provide the sputtering of the solid precursor PS2, releasing from the latter and into the interior of the reaction chamber RC, the alloy elements to be ionically bombarded against the surfaces of the metallic pieces 1 negatively polarized by the pulsating DC power supply 10; and h') providing the exhaustion of the gas load from the interior of the reaction chamber RC.

As already mentioned in relation to the treatment process by cracking the precursor, the tubular sputtering chamber 40 is built, for example, in the form of a cup having one end open to the interior of the reaction chamber RC, or in the form of a tube having both ends open to the interior of the reaction chamber RC, also defining, preferably, a hollow cathode in association with the anode 2 of the system of anode 2 and cathode 3 of the reaction chamber RC of the reactor R.

The ionization of the gas load and of the solid precursor may be carried out by DC electric discharge, under a low pressure atmosphere, generating plasma and producing the alloy elements for the surface treatment of the metallic pieces 1.

Independently of the use of one, the other, or even both the treatment processes described above, it is preferable that the ionizable gas load is admitted in the interior of the reaction chamber RC by the upper part of the reactor R, and according to a vertical axis of symmetry of the reaction chamber RC and of the arrangement of the metallic pieces 1 on the support S, assuring a more homogeneous distribution of the ionizable gas load around the metallic pieces under treatment, thus positively contributing for the uniformity of the surface treatment of the pieces.

The treatment processes described above may be carried out in a plasma reactor of the type presenting, according to a first embodiment of the invention, the basic characteristics already previously defined for the different process steps previously described, as well as certain constructive features which will be described hereinafter.

The reactor R presents, as basic elements, a reaction chamber RC, kept hermetic for the generation of plasma in the interior thereof, in which are provided: a support S carrying the metallic pieces 1; a system of anode 2 and cathode 3 having one of the electrodes 2a thereof associated with a high voltage pulsating DC power supply 10; an inlet 4 of ionizable gas load hermetically coupled to an ionizable gas supply source IGS; and an outlet 6 for exhaustion of the gas load.

In a first embodiment, the reactor R of the invention further comprises a metallic housing 8 defining, internally, a reaction chamber RC provided with the elements already described; an inlet of liquid or gas precursor 5; a vacuum system 7 hermetically connected to the outlet 6 of exhaustion of gas load; and a heating means 60 mounted inside or outside the metallic housing 8, in order to heat the interior of the reaction chamber RC to a working temperature of the reactor R.

The metallic housing 8 is preferably formed in refractory steel (such as, for example, stainless steel AISI 310 or 309) and the support S in refractory steel (such as, for example, stainless steel AISI 310 or 309). Other materials may be used, depending on the temperatures suitable for the treatment.

The metallic housing 8 presents a prismatic form, for example cylindrical, with a surrounding lateral wall 8a and an upper end wall 8b, being inferiorly open so as to be removably and hermetically seated and locked over a base structure B on which are suitably mounted component parts operatively associated with the reactor R.

In the construction of figure 6, the heating means 60 in mounted internally to the metallic housing 8, in order to heat the interior of the reaction chamber RC, for example, producing heat radiation to the interior of the latter, thus allowing the surface treatments to be carried out at temperatures from 100°C to 1300°C. The plasma reactor R is also externally provided with an outer shell 9, usually formed in carbon steel or stainless steel.

The heating means 60 is usually formed by at least one resistor 61 mounted inside the reaction chamber RC, internally to the metallic housing 8 and surrounded by thermal protections 62, located between the heating means 60 and the metallic housing 8 and which may be provided in one or more layers. It may be also provided a cooling system 70 comprising at least one inlet 71 of chilled fluid and at least on outlet 72 of heated fluid.

The cooling system 70 may further comprise at least one heat exchanging means 73, positioned external to the outer shell 9 and including at least one air circulation system 74, through which air is forced to pass through the heat exchanging means 73.

The intensity of heat exchange inside the cooling system 70 may be controlled in different manners such as, for example, by varying the operational velocity of the cooling fluid or by varying the power applied to the resistor 61.

In the construction illustrated in figure 6, and which is repeated in figure 7, the support S is formed by a plurality of ordering frames S1 provided horizontally or substantially horizontally and which, in such way, define planes for supporting or mounting the pieces orthogonally or substantially orthogonally to the direction of feeding the gas load through the inlet 4, and to the direction of releasing the alloy elements, both from the tubular cracking chamber 20 and from the tubular sputtering chamber 40. Said arrangement frames have through holes, in order to allow the gas load to reach the pieces mounted on the arrangement frames, as already described in the co-pending patent application PI0803774-4 (WO2009/149526) .

The support S may be built in different manners such as, for example, in the form of multiple arrangement frames S1, which are parallel and spaced from each other, defining the electrodes 3a of the system of anode 2 and cathode 3, which are electrically coupled to the pulsating DC power supply 10, of plasma and polarization, and interleaved by elements which define the other electrodes 2a of said system, each of said arrangement frames carrying at least one metallic piece 1 to be treated.

According to this first constructive form of the reactor R of the invention, the anode 2 is connected to a first electrode 2a and to a ground 2b, and the cathode 3 is connected to the support S, operating as the other electrode 3a of the system of anode 2 and cathode 3, and to a negative potential of the high voltage pulsating DC power supply 10. The support S carries, statically, the metallic pieces 1 and is associated with the cathode 3 inside the reaction chamber RC.

In this embodiment, the reactor R comprises a tubular cracking chamber 20 of a flow of liquid or gas precursor (not illustrated) to be admitted therein, having one end 21 open to the interior of the reaction chamber RC and being associated with a high voltage energy source 30 for dissociating the molecules of the precursor and releasing them to the interior of the reaction chamber RC.

According to the construction illustrated in figures 6 and 7, the tubular cracking chamber 20 is positioned inside the reaction chamber RC, above the support S, being subjected to the working temperature of the interior of the reaction chamber RC and receiving the flow of liquid or gas precursor (not illustrated) by means of a supply tube 25 from a source of liquid or gas precursor PS1, external to the reactor R, with the supply tube 25 penetrating into the interior of the reactor R by the inlet 5 of liquid or gas precursor.

In order to obtain a high efficiency in the cracking of the liquid or gas precursor, without affecting the operational temperature inside the reaction chamber RC, the tubular cracking chamber 20 is built so as to define a hollow cathode operating in association with the anode 2 of the system of 2 and cathode 3 of the reaction chamber RC of the reactor R, upon applying a high voltage discharge from the high voltage energy source 30.

In the illustrated embodiment, the energization of the tubular cracking chamber 20 is effected by the supply tube 25 of liquid or gas precursor.

Depending on the precursor to be cracked, the cracking may produce atoms such as, for example, oxygen and nitrogen, not desired to the surface treatment to be carried out in reactor R.

The cracking proposed by the present invention may form, besides the desired atoms of chrome, silicon and others required for the surface treatment, undesired atoms for the treatment and which are common in the chemical formulation of certain precursors and which may negatively affect the treatment layer to be formed on the pieces. Examples of such undesired atoms are defined by oxygen and nitrogen.

Due to the problem mentioned above with certain precursors to be cracked, the invention may further comprise a filtering device 90 located immediately downstream the respective at least one open end 21 of the tubular cracking chamber 20 and able to chemically react with the undesired atoms produced in the cracking of the precursor inside the tubular cracking chamber 20, keeping said atoms retained in the filtering device 90 and allowing only desirable atoms of the alloy elements to be ionically bombarded against the surface of the metallic pieces 1 negatively polarized by the pulsating DC power supply 10.

In the constructive form illustrated in figure 7, the filtering device 90 is defined by a tube 91 built or internally coated with a material, which may chemically react with said undesirable atoms, in which case it may be positioned and fixed adjacent to and axially aligned with the respective at least one open end 21 of the tubular cracking chamber 20, in order to make the precursor, which is cracked and released by one open end 21 of the tubular cracking chamber 20, to pass along the interior of the tube 91 before reaching the interior of the reaction chamber RC.

It should be understood that the filtering device 90 may be defined by a tubular extension of the tubular cracking chamber 20 itself, in a single piece or in a separate piece, being differentiated from the tubular cracking chamber 20 only by the reactant material defining the inner surface of the tube 91. A reactant material may be, for example, titanium, defining the tube 91 itself or being in the form of titanium powder provided inside said tube 91. The titanium reacts with the undesired atoms, forming titanium nitrate or titanium oxide when the cracked precursor releases oxygen and nitrogen, these oxides/nitrates being very stable, keeping the undesired atoms imprisoned in the filtering device 90. From time to time, the filtering device may be replaced for renewing its capacity of reaction and retention of the undesired atoms generated by the cracking of certain precursors.

The reactor R described above may further comprise, alternatively or together with the tubular cracking chamber 20, a tubular sputtering chamber 40 carrying the solid precursor, having one end 41 open to the interior of the reaction chamber RC and being associated with an electric power supply 50, in order to provide the sputtering of the solid precursor (not illustrated) and the release of its alloy elements ionically bombarded against the metallic pieces 1 negatively polarized by the pulsating DC power supply 10, of plasma and polarization.

According to the construction illustrated in figures 6 and 7, the tubular sputtering chamber 40 is positioned inside the reaction chamber RC, above the support S, being subjected to the working temperature of the interior of the reaction chamber RC and carrying the solid precursor (not illustrated) which may be defined, by being incorporated, in the inner structure of the tubular sputtering chamber 40, defining the interior of the latter, or it may also be defined by a gas flow containing solid particles of the alloy element and which is carried to said chamber, from a source of solid precursor PS2 external to the reactor R, by means of a supply tube 45 which penetrates in the interior of the reactor R through an inlet 5a for admission of the solid precursor.

In order to obtain a high efficiency in the sputtering of the solid precursor, without affecting the operational temperature inside the reaction chamber RC, the tubular sputtering chamber 40 is built in order to define a hollow cathode, which operates in association with the anode 2 of the system of anode 2 and cathode 3 of the reaction chamber RC of the reactor R, upon application of a high voltage discharge from the electric power supply 50.

In the illustrated embodiment, the energization of the tubular sputtering chamber 40 is done by the supply tube 45 of solid precursor itself.

Independently of providing one or both treatment chambers described above, it is preferable that the ionizable gas load is admitted in the interior of the reaction chamber RC through the upper part of the reactor R and according to a vertical axis of symmetry of the reaction chamber RC and of the arrangement of the metallic pieces 1 on the support S, assuring a more homogeneous distribution of the ionizable gas load around the metallic pieces under treatment, thus positively contributing for the uniformity of the surface treatment of the pieces.

The tubular chambers of cracking and sputtering 20 and 40 use a pulsating direct current source, in order to obtain higher electron density and thus allow for a higher efficiency both for cracking and for sputtering.

The ionizable gas load may be admitted into and exhausted from the reaction chamber RC by means of the operation of control valves, not illustrated, of automatic actuation, for example, via command from a control unit or other specific controller (not illustrated), and said control valves may also be manually actuated.

The plasma reactor R illustrated in figure 7 comprises all the components presented for the reactor R of figure 6 and already described above, except by the fact that the heating means 60 is mounted externally in relation to the reaction chamber RC, in order to heat the interior of the latter, for example, by heat radiation into the metallic housing 8 and from there to the interior of the reaction chamber RC, allowing the surface treatments to be carried out under temperatures from 100°C to 1000°C.

The insulation of the reactor R in order to increase the thermal efficiency is carried out by means of thermal protections 64 located between the resistor 61 and the outer shell 9 of the reactor R.

The provision of the heating means 60 externally to the reaction chamber RC prevents the presence of cold walls inside the latter, that is, in the environment in which is processed the plasma treatment to which the metallic pieces 1 are subjected. It is necessary to avoid the presence of cold walls in the interior of the reaction chamber RC in certain types of treatment, in order to avoid condensation of impurities able to impair the surface treatment.

In this configuration of figure 7, the water-run cooling system 70 has the objective of cooling the base B of the reactor R, preventing the connections provided therein from being damaged. It may also be provided an air cooling system 80 to cool the reactor R, after the execution of the surface treatment, comprising at least one air source 81 to blow cool air in the interior of the gap formed between the metallic housing 8 and the outer shell 9, by means of a respective cold air inlet 82 and with at least one hot air outlet 83 being provided.

The surface treatments proposed by the present invention are normally carried out under temperatures from 100°C to 1300°C, the treatment temperatures being obtained by the heating means 60 and by the ionic bombardment (ions and electrons from the ionized precursor) provided by the negative polarization of the metallic pieces 1 electrically connected to the pulsating DC power supply 10.

The use of an independent source of resistive heating allow the plasma conditions to be independent from the heating parameters. Another advantage of the resistive heating system is allowing a homogeneous temperature to be obtained inside the reaction chamber RC.

The gas load to be ionized in the reaction chamber RC, as well as the liquid precursor, are subjected to a subatmospheric pressure from around 1.33x10¹ Pascal (0.1 Torr) to 1.33x10⁴ Pascal (100 Torr), said pressures being obtained by action of the vacuum system 7, which comprises, for example, a vacum pump.

The operations of ionization of the gas load and of the solid, liquid or gas precursor use DC electric discharge, which may be pulsating, under a low pressure atmosphere such as defined above, in order to generate plasma, producing the items and compounds desired for the surface treatment of the material to be treated.

The plasma reactor R of the present invention allows, when provided with the tubular chambers of cracking 20 and of sputtering 40, to obtain chemical elements supplied by said chambers and which are bombarded (ions e electrons) against the surface of the metallic pieces 1 negatively polarized in a metallic tube. These chemical elements may react with each other and form other compounds to be directed to the surface of the material to be treated.

The process of the present invention may be used for metallic pieces 1 produced by powder metallurgy or other manufacturing processes of pieces (for example, machining, pressing, cold draw, and others). The treatments have duration from 15 minutes to 6 hours, which time may be altered for longer or shorter durations as a function of the thickness and mechanical properties desired for the layer to be formed in the surface of the metallic pieces 1.

Metallic materials were treated in an industrial scale plasma reactor R and were analyzed by optical and electronical microscopes, as well as analyzed by x-ray diffraction. The results show that it is possible to obtain a uniform layer along the entire extension of the material to be treated, either horizontally or vertically.

### Surface treatments

One treatment that may be carried out in the reactor R provided with the tubular cracking chamber 20 is the one of silicon oxide deposition over the surface of the metallic pieces 1. In this treatment, the pressure inside the reaction chamber RC is reduced to values from 0.1 to 5 torr and a liquid precursor is used, which may be the hexamethyldisiloxane, the silane or others, containing the silicone to be introduced in the tubular cracking chamber 20. Through the inlet 4 of ionizable gas of the reaction chamber RC may be supplied the gases argon and oxygen. Thus, there is the formation pf silicone oxide in the form of a gas, being ionized by the pulsating DC power supply 10 connected to the cathode 3 and attracted towards the metallic pieces 1 negatively polarized. The temperatures used in this type of surface treatment of the example vary from 100°C to 500°C, while the temperatures inside the tubular cracking chamber 20 vary from 700°C to 1200°C.

Another surface treatment that may be carried out in the reactor R of the present invention using a tubular cracking chamber 20 is the deposition of silicone nitrate. In this case, the pressure inside the reaction chamber RC may be reduced to values from 0.1 to 5 torr. A liquid precursor is used, being defined by the hexamethyldisiloxane, by the silane or others containing silicone and being introduced in the tubular cracking chamber 20. The gases argon, hydrogen and nitrogen are introduced in different proportions in the reaction chamber RC through the inlet 4. There is the formation of silicon nitride in the form of a gas, being ionized by the pulsating DC power supply 10. The temperatures of operation and cracking are the same as mentioned for the example above.

Another treatment that may be carried out in the reactor R of the present invention, when provided with the tubular sputtering chamber 40, is the surface enrichment by chrome and nickel. In this case, the pressure inside the reaction chamber R is reduced to values which may vary from 0.1 to 10 torr and are used two tubular sputtering chambers 40, of which only one is illustrated in figures 6 and 7, in order to carry out the sputtering of respective solid precursors, one of which containing chrome and the other containing nickel. The gases used in this example are argon and hydrogen, fed by the inlet 4 in different proportions. Once present in the reaction chamber RC and already sputtered in the respective tubular sputtering chambers 40, the chrome and the nickel are ionized by the pulsating DC power supply 10 and attracted towards the metallic pieces 1. The operation temperatures used in the reaction and sputtering chamber RC vary, respectively, from 700°C to 1300°C and from 700°C to 1200°C.

Another treatment which may be carried out in the reactor R of the present invention, provided with a tubular cracking chamber 20, is the one of "*Diamond Like Carbon*" (DLC). In this treatment, the pressure inside the reaction chamber RC may be reduced to values from 0.1 to 10 torr. The liquid precursor hexamethyldisiloxane is used, being cracked in the tubular cracking chamber 20. On the precursor is cracked, the resulting chemical elements are ionized by the pulsating DC power supply 10 and attracted to the metallic pieces 1. In the inlet 4 are admitted hydrogen and argon in different proportions. Thus, in the surface of the metallic pieces 1 is formed a layer composed by silicon, carbon and hydrogen, which will function as a base for the deposition of the DLC.

Once the base layer is formed, then begins the deposition of the DLC, by interrupting the supply of liquid precursor for the introduction, in the tubular cracking chamber 20, methane gas. In the inlet 4 is kept the supply of hydrogen and argon in different proportions. One the methane is cracked, the resulting carbon and hydrogen are ionized by the pulsating DC power supply 10, of plasma and polarization, and attracted towards the surface of the metallic pieces 1, generating the DLC. The temperatures used inside the reaction chamber RC vary from 100°C to 600°C and the temperatures in the tubular cracking chamber 20 vary from 700°C to 1000°C.

Still another treatment that may be carried out in the reactor R of the present invention, using a tubular sputtering chamber 40, is the deposition of chromium nitride. In this case, the pressure inside the reaction chamber RC e reduced to values from 0.1 to 10 torr. The sputtering of the chrome precursor and the ionization of the nitrogen introduced by the inlet 4 allow the formation of chromium nitride in the form of a gas inside the reaction chamber RC. Besides the nitrogen, the inlet 4 also receives the hydrogen gas, with the proportion between the two gases varying substantially. Once present in the reaction chamber RC, the chromium nitride is ionized by the pulsating DC power supply 10 and attracted towards the metallic pieces 1. The temperatures used inside the reaction chamber RC vary from 300°C to 700°C, and the temperatures in the tubular sputtering chamber 40 vary from 700°C to 1200°C.

### Surface Treatments

The surface treatments allow generating new phases in the surface layer, such as: Silicon Nitride, Silicon Oxide, Chromium Nitride, Boron Nitride, Intermetallics (FeAl or NiAl) and Al₂O₃, as well as DLC and doped DLC, besides promoting an enrichment of the surface layer of finished components with alloy elements of interest, such as Cr, Ni, Mo, among others.

One treatment that may be carried out in the reactor R provided with the tubular cracking chamber 20 is the deposition of Silicon Oxide over the surface of the metallic pieces 1. In this treatment, the pressure inside the reaction chamber RC is reduced to values from 0.1 to 5 torr and a liquid precursor is used, which may be the hexamethyldisiloxane, the silane or others containing the silicon to be introduced in the tubular cracking chamber 20.

Through the inlet 4 of ionizable gas of the reaction chamber RC may be supplied the gases argon and oxygen. Thus there is the formation of Silicon Oxide in the form of a gas, the latter being ionized by the pulsating DC power supply 10 connected to the cathode 3 and attracted towards the negatively polarized metallic pieces 1.

The temperatures used in this type of surface treatment of the example vary from 100°C to 500°C, while the temperatures inside the tubular cracking chamber 20 vary from 700°C to 1200°C.

Another surface treatment that may be carried out in the reactor R of the present invention, using a tubular cracking chamber 20, is the deposition of Silicon Nitride. In this case, the pressure inside the reaction chamber RC may be reduced to values from 0.1 to 5 torr. A liquid precursor is used, being defined by the hexamethyldisiloxane, by the silane or others containing silicone and which is introduced in the tubular cracking chamber 20.

The gases argon, hydrogen and nitrogen, in different proportions, are introduced in the reaction chamber RC through the inlet 4. Then there is the formation of Silicon Nitride in the form of a gas, the latter being ionized by the pulsating DC power supply 10. The operation and cracking temperatures are the same mentioned for the example above.

Another treatment that may be carried out in the reactor R of the present invention, when provided with the tubular sputtering chamber 40, is the enrichment of the surface layer with chrome and nickel. In this case, the pressure inside the reaction chamber R is reduced to values which may vary from 0.1 to 10 torr and two sputtering tubular chambers 40 are used, of which only one is illustrated in figures 6 and 7, in order to carry out the sputtering of respective solid precursors, one of which containing chrome and the other containing nickel. The gases used in this example are the argon and the hydrogen, supplied through the inlet 4 in different proportions. Once present in the reaction chamber RC, already sputtered in the respective sputtering tubular chambers 40, the chrome and the nickel are ionized by the pulsating DC power supply 10 and attracted towards the metallic pieces 1. The operation temperatures used in the reaction and sputtering chamber RC vary, respectively, from 700°C to 1300°C and from 700°C to 1200°C. Other elements may be used in this example in order to obtain an enriched layer in the surface of pieces. These other elements may be, for example: manganese, silicon, molybdenum, vanadium, carbon, among others.

Another treatment which may be carried out in the reactor R of the present invention, provided with a tubular cracking chamber 20, in the coating with a film of "*Diamond Like Carbon*" (DLC). In this case, the pressure inside the reaction chamber RC may be reduced to values from 0.1 to 10 torr. The liquid precursor hexamethyldisiloxane is used, which is cracked in the tubular cracking chamber 20.

Once the precursor is cracked, the resulting chemical elements are ionized by the pulsating DC power supply 10 and attracted towards the metallic pieces 1. Through the inlet 4, are admitted hydrogen and argon in different proportions. Thus, is formed in the surface of the metallic pieces 1, a layer composed by silicon, carbon and hydrogen, which will serve as a base for the deposition of the DLC.

Once the base layer is formed, then begins the deposition of the DLC, by interrupting the supply of liquid precursor for the introduction, in the tubular cracking chamber 20, the methane gas. Through the inlet 4 is maintained the supply of hydrogen and argon in different proportions. Once the methane is cracked, the resulting carbon and hydrogen are ionized by the pulsating DC power supply 10 and attracted towards the surface of the metallic pieces 1, generating the DLC. The temperatures used in the interior of the reaction chamber RC vary from 100°C to 600°C and the temperatures in the tubular cracking chamber 20 vary from 700°C to 1000°C.

Still in relation to the DLC film, it may be doped with other metallic chemical elements, such as Fe, Cr, Ni and Mo. To this end is used, together with the cracking chamber 20, the sputtering chamber 40. During the formation of the DLC, as mentioned above, metallic atoms provided by the sputtering chamber 40 are ionized by the pulsating DC power supply 10 and attracted towards the surface of the metallic piece 1, doping the DLC film.

Still another treatment which may be carried out in the reactor R of the present invention, using a tubular sputtering chamber 40, is the deposition of chromium nitride. In this case, the pressure inside the reaction chamber RC is reduced to values from 0.1 to 10 torr. The sputtering of the chrome precursor and the ionization of the nitrogen introduced through the inlet 4 allow the formation of chromium nitride in the form of a gas inside the reaction chamber RC. Besides the nitrogen, the inlet 4 also is fed with the hydrogen gas, with the proportion between the two gases being varied. Once present in the reaction chamber RC, the chromium nitride is ionized by the pulsating DC power supply 10 and is attracted towards the metallic pieces 1. The temperatures used inside the reaction chamber RC vary from 300°C to 700°C and the temperatures in the tubular sputtering chamber 40 vary from 700°C to 1200°C.

Another treatment that may be carried out is the formation of Boron Nitride. To this end is used a liquid precursor containing boron, which is cracked in the cracking chamber 20. Once the molecule containing boron is cracked, the resulting chemical elements are ionized by the pulsating DC power supply 10 and attracted towards the metallic pieces 1. The resulting chemical elements are ionized by the pulsating DC power supply 10 and attracted towards the metallic pieces 1. In the surface of the metallic piece 1, the boron reacts with the nitrogen, forming Boron Nitride. Making use also of the sputtering chamber, there may be further added to the Boron Nitride metallic chemical elements, such as Fe, Co and W, with the objective of doping the Boron Nitride. In this case, the pressure inside the reaction chamber RC may be reduced to values from 0.1 to 50 torr. The temperatures used inside the reaction chamber RC vary from 900°C to 1200°C and the temperatures in the tubular sputtering chamber 40 vary from 700°C to 1200°C.

Another treatment that may be carried out using the present invention is the formation of intermetallics, such as the FeAl or NiAl. In the case of the formation of FeAl it is used two liquid precursors mixed, one containing the Fe and the other containing the Al or, in the case of the formation of NiAl, it is used a precursor containing Ni and the other containing Al. Such precursors are cracked in the cracking chamber 20 and reach with each other forming the FeAl or the NiAl. Such compounds are polarized by the pulsating DC power supply 10 and are attracted towards the surface of the metallic piece 1. In this case, the pressure inside the reaction chamber RC may be reduced to values from 0.1 to 10 torr. The temperatures used in the interior of the reaction chamber RC vary from 700°C to 1200°C and the temperatures in the tubular cracking chamber 20 vary from de 1000°C to 1300°C.

Another treatment that may be carried out using the present invention is the formation of alumina (Al₂O₃), in which is used a precursor containing the Al and the oxygen in introduced through the inlet 4. The elements provided by the cracking and the oxygen are polarized by the pulsating DC power supply 10 and are attracted towards the surface of the metallic piece 1. In this case, the pressure inside the reaction chamber RC may be reduced to values from 0.1 to 10 torr. The temperatures used in the interior of the reaction chamber RC vary from 700°C to 1200°C and the temperatures in the tubular cracking chamber 20 vary from 1000°C to 1300°C.

It is important to observe that when it is desired to use elements which have great affinity for oxygen (stable oxides) the more suitable path is to use a cracker, due to the fact that if is used a solid source there will be the formation, in the surface of said source, of the oxide of the element due to its stability, impairing the treatment process. Elements which form high stability oxides are, for example: Si, Ti, Mn, Cr.

While only one way of carrying out the present invention has been illustrated herein by means of an example, it should be understood that alterations can be made in the form and arrangement of the constitutive elements, without departing from the constructive concept defined in the claims that accompany the present specification.

## Claims

1. A process for the thermochemical treatment of the surface of metallic pieces, in a plasma reactor (R) having a reaction chamber (RC) provided with: a support (S) carrying the metallic pieces (1); a system of anode (2) and cathode (3) having one of its electrodes (2a, 3a) associated with a pulsating DC power supply (10); an inlet (4) of ionizable gas load; an inlet of liquid or gas precursor (5); and an outlet (6) for exhaustion of gas load, comprising the steps of:
a) connecting the anode (2) to a first electrode (2a) and to a ground (2b) and connecting the cathode (3) to the support (S), operating as the other electrode (3a) of the system of anode (2) and cathode (3), and to a negative potential of the pulsating DC power supply (10);
b) statically positioning the metallic pieces (1) on the support (S) associated with the cathode (3) in the interior of the reaction chamber (RC);
c) surrounding the support (S) and the metallic pieces (1) with an ionizable gas load supplied to the reaction chamber (RC) through the inlet (4);
d) heating the interior of the reaction chamber (RC) to a working temperature;
e) applying to the cathode (3), associated with the support (S) and with the metallic pieces (1), an electric discharge in order to cause the formation of a gas plasma of ions having a high kinetic energy surrounding the metallic pieces (1) and the support (S);
f) admitting a flow of liquid or gas precursor in at least one tubular cracking chamber (20) having at least one end (21) open to the interior of the reaction chamber (RC) and being associated with a high voltage energy source (30);
g) applying a potential difference between the at least one tubular cracking chamber (20) and the anode (2) of the system of anode (2) and cathode (3) for dissociating the molecules of the precursor admitted into said tubular cracking chamber (20), releasing, to the interior of the reaction chamber (RC), the atoms of the alloy elements to be ionically bombarded against the surfaces of the metallic pieces (1) negatively polarized by the pulsating DC power supply (10); and
h) providing the exhaustion of the gas load from the interior of the reaction chamber (RC),
the process being **characterized in that** the tubular cracking chamber (20) is subjected to the working temperature in the interior of the reaction chamber (RC).

2. The process, as set forth in claim 1, **characterized in that** the tubular cracking chamber (20) defines a hollow cathode in association with the anode (2) of the system of anode (2) and cathode (3) of the reaction chamber (RC) of the reactor (R).

3. The process, as set forth in any of claims 1 and 2, **characterized in that** the ionizable gas load further comprises adding a gas selected from oxygen, hydrogen, nitrogen and argon to react with the atoms or molecules obtained by cracking of the liquid precursor, thus forming compounds directed to the metallic pieces (1) with a kinetic energy resulting from the acceleration caused by the potential difference applied to the system of anode (2) and cathode (3).

4. The process, as set forth in any of claims 1 to 3, **characterized in that** the cracked precursor, released from the tubular cracking chamber (20) and to have the desirable atoms of the alloy elements ionically bombarded against the surface of the metallic pieces (1), has eventual undesirable atoms retained in a filtering device (90) located immediately downstream from said open end (21) of the tubular cracking chamber (20)and **in that** the retention of undesirable atoms of the cracked precursor is obtained by chemical reaction between said atoms and the filtering device (90).

5. The process, as set forth in any of claims 1 to 4, **characterized in that** it further comprises, before, during or after the steps of surface thermochemical treatment by cracking of the liquid or gas precursor, the steps of:
a') if not already previously carried out, connecting the anode (2) to a first electrode (2a) and to a ground 2b and connecting the cathode (3) to the support (S), operating as the other electrode (3a) of the system of anode (2) and cathode (3), and to a negative potential of the pulsating DC power supply (10);
b') if not already previously carried out, statically positioning the metallic pieces (1) on the support S associated with the cathode (3) inside the reaction chamber RC;
c') if not already previously carried out, surrounding the support (S) and the metallic pieces (1) with an ionizable gas load fed to the reaction chamber (RC) through the inlet (4);
d') if not already previously carried out, heating the interior of the reaction chamber (RC) to a working temperature;
e') applying to the cathode (3), associated with the support (S) and to the metallic pieces (1), an electric discharge in order to cause the formation of a ion gas plasma, having high kinetic energy, surrounding the metallic pieces (1) and the support (S);
f') providing a solid precursor defining the interior of at least one tubular sputtering chamber (40), having one end open to the interior da reaction chamber (RC) and being associated with an electric power supply (50);
g') applying a potential difference between the at least one tubular sputtering chamber (40) and the anode (2) of the system of anode (2) and cathode (3) in order to provide the sputtering of the solid precursor, releasing from the latter and into the interior of the reaction chamber (RC), the alloy elements to be ionically bombarded against the surfaces of the metallic pieces (1) negatively polarized by the pulsating DC power supply (10); and
h') providing the exhaustion of the gas load from the interior of the reaction chamber RC.

6. The process, as set forth in claim 5, **characterized in that** the at least one tubular sputtering chamber (40) is subjected to the working temperature in the interior of the reaction chamber (RC).

7. The process, as set forth in any of claims 5 and 6, **characterized in that** the at least one tubular sputtering chamber (40) defines a hollow cathode associated with the anode (2) of the system of anode (2) and cathode (3) of the reaction chamber (RC) of the reactor (R).

8. The process, as set forth in any of claims 5 to 7, **characterized in that** the ionization of the gas load and of the solid precursor is carried out by a DC electric discharge under a low pressure atmosphere, generating plasma and producing the alloy elements for the surface treatment of the metallic pieces (1).

9. A reactor for the thermochemical treatment of the surface of metallic pieces, said plasma reactor (R) having a metallic housing (8) defining, internally, a reaction chamber (RC) provided with: a support (S) carrying the metallic pieces (1); a system of anode (2) and cathode (3) associated with a pulsating DC power supply (10); an inlet (4) of ionizable gas load; an inlet (5) of liquid or gas precursor; an outlet (6) of exhaustion of gas load, connected to a vacuum system (7); and a heating means (60) mounted to the metallic housing (8) in order to heat the interior of the reaction chamber (RC) to a working temperature, the reactor comprising:
- the anode (2) connected to a first electrode (2a) and to a ground (2b), and the cathode (3) connected to the support (S), operating as the other electrode (3a) of the system of anode (2) and cathode (3), and to a respective negative potential of the pulsating DC power supply (10);
- the support (S) carrying, statically, the metallic pieces (1) and being associated with the cathode (3) in the interior of the reaction chamber (RC);
- at least one tubular cracking chamber (20) of a respective flow of liquid or gas precursor to be admitted therein, having at least one end (21) open to the interior of the reaction chamber (RC) and being associated with a high voltage energy source (30) for dissociating the molecules of the precursor and their release to the interior of the reaction chamber (RC), the reactor being **characterized in that** the at least one tubular cracking chamber (20) is positioned in the interior of the reaction chamber (RC), above the support (S) and is subjected to the working temperature of the interior of the reaction chamber (RC) and receives the flow of liquid or gas precursor by means of a supply tube (25) coming from a source (PS1) of liquid or gas precursor, external to the reactor.

10. The reactor, as set forth in claim 9, **characterized in that** the at least one tubular cracking chamber (20) defines a hollow cathode in association with the anode (2) of the system of anode (2) and cathode (3) of the reaction chamber (RC) of the reactor (R).

11. The reactor, as set forth in any of the claims 9 and 10, **characterized in that** the energization of the at least one tubular cracking chamber (20) is carried out by the supply tube (25) itself of liquid or gas precursor.

12. The reactor, as set forth in any of the claims 9 to 11, **characterized in that** it further comprises a filtering device (90) located immediately downstream from the respective at least one open end (21) of the tubular cracking chamber (20) and which is able to chemically react with eventual undesirable atoms released by the tubular cracking chamber (20) together with the desirable atoms of the alloy elements to be ionically bombarded against the surface of the metallic pieces (1), said eventual undesirable atoms being retained in the filtering device (90), and **in that** the filtering device (90) is defined by a tube (91) built or internally lined with a material that may react with said undesirable atoms, and is positioned and affixed adjacent to and axially aligned with said open end (21) of the tubular cracking chamber (20).

13. The reactor, as set forth in claim 12, **characterized in that** the filtering device (90) is defined by a tubular extension of the tubular cracking chamber (20) itself.

14. The reactor, as set forth in any of the claims 9 to 13, **characterized in that** it further comprises:
- at least one tubular sputtering chamber (40) carrying the solid precursor, having one end (41) open to the interior of the reaction chamber (RC) and being associated with an electric power supply (50), in order to provide the sputtering of the solid precursor and the release of its alloy elements ionically bombarded against the metallic pieces (1) negatively polarized by the pulsating DC power supply (10).

15. The reactor, as set forth in claim 14, **characterized in that** the at least one tubular sputtering chamber (40) is positioned in the interior of the reaction chamber (RC), above the support (S) and is subjected to the working temperature of the interior of the reaction chamber (RC).

16. The reactor, as set forth in claim 15, **characterized in that** the at least one tubular sputtering chamber (40) defines a hollow cathode in association with the anode (2) of the system of anode (2) and cathode (3) of the reaction chamber (RC) of the reactor (R).

17. The reactor, as set forth in claim 16, **characterized in that** the solid precursor is defined by the respective tubular sputtering chamber (40).

## Patentansprüche

1. Verfahren zur thermochemischen Behandlung der Oberfläche von metallischen Teilen in einem Plasmareaktor (R), der eine Reaktionskammer (RC) hat, die versehen ist mit: einer Halterung (S), die die metallischen Teile (1) trägt; einem System aus Anode (2) und Kathode (3), wobei eine seiner Elektroden (2a, 3a) mit einer pulsierenden Gleichstrom-Leistungsversorgung (10) verbunden ist; einem Einlass (4) für eine Beladung mit ionisierbarem Gas; einem Einlass (5) für flüssiges oder Gasvorprodukt; und einem Auslass (6) zum Ausströmen von Gasbeladung, wobei die Schritte enthalten sind:
a) Verbinden der Anode (2) mit einer ersten Elektrode (2a) und mit einer Erdung (2b) und Verbinden der Kathode (3) mit der Halterung (S), die als die andere Elektrode (3a) des Systems von Anode (2) und Kathode (3) arbeitet, und mit einem negativen Potenzial der pulsierenden Gleichstrom-Leistungsversorgung (10);
b) statisches Positionieren der metallischen Teile (1) auf der Halterung (S), die im Inneren der Reaktionskammer (RC) mit der Kathode (3) verbunden ist;
c) Umgeben der Halterung (S) und der metallischen Teile (1) mit einer Beladung von ionisierbarem Gas, das der Reaktionskammer (RC) durch den Einlass (4) zugeführt wird;
d) Aufheizen des Inneren der Reaktionskammer (RC) auf eine Arbeitstemperatur;
e) Anlegen einer Entladung an die Kathode (3), die mit der Halterung (S) und mit den metallischen Teilen (1) verbunden ist, um die Bildung eines Gasplasmas von Ionen zu verursachen, die eine hohe kinetische Energie haben, das die metallischen Teile (1) und die Halterung (S) umgibt;
f) Zulassen einer Strömung von flüssigem oder Gasvorprodukt in wenigstens eine rohrartige Spaltungskammer (20), von der wenigstens ein Ende (21) zum Inneren der Reaktionskammer (RC) hin offen ist und die mit einer Hochspannungsenergiequelle (30) verbunden ist;
g) Anlegen einer Potenzialdifferenz zwischen der wenigstens einen rohrartigen Spaltungskammer (20) und der Anode (2) des Systems von Anode (2) und Kathode (3), um die Moleküle des Vorproduktes, die in die rohrartige Spaltungskammer (20) gelassen wurden, zu dissoziieren, wodurch zum Inneren der Reaktionskammer (RC) die Atome der Legierungselemente freigegeben werden, um ionisch gegen die Oberflächen der metallischen Teile (1) geschleudert zu werden, die durch die pulsierende Gleichstrom-Leistungsversorgung (10) negativ polarisiert sind; und
h) Bereitstellen der Ausströmung der Gasbeladung aus dem Inneren der Reaktionskammer (RC),
wobei das Verfahren **dadurch gekennzeichnet ist, dass** die rohrartige Spaltungskammer (20) der Arbeitstemperatur im Inneren der Reaktionskammer (RC) ausgesetzt ist.

2. Verfahren nach Anspruch 1, **dadurch gekennzeichnet, dass** die rohrartige Spaltungskammer (20) eine hohle Kathode in Verbindung mit der Anode (2) des Systems von Anode (2) und Kathode (3) der Reaktionskammer (RC) des Reaktors (R) definiert.

3. Verfahren nach einem der Ansprüche 1 und 2, **dadurch gekennzeichnet, dass** die Beladung mit ionisierbarem Gas ferner das Hinzufügen eines Gases enthält, das ausgewählt ist aus Sauerstoff, Wasserstoff, Stickstoff und Argon, um mit den Atomen oder Molekülen zu reagieren, die durch Spalten des flüssigen Vorproduktes erhalten wurden, wodurch Mischungen gebildet werden, die auf die metallischen Teile (1) mit einer kinetischen Energie gerichtet wird, die aus der Beschleunigung resultiert, die durch die Potenzialdifferenz verursacht wird, die an das System von Anode (2) und Kathode (3) angelegt wird.

4. Verfahren nach einem der Ansprüche 1 bis 3, **dadurch gekennzeichnet, dass** von dem gespaltenen Vorprodukt, das aus der rohrartigen Spaltungskammer (20) freigegeben wird und damit die erwünschten Atome der Legierungselemente ionisch gegen die Oberfläche der metallischen Teile (1) geschleudert werden, eventuell unerwünschte Atome in einer Filtervorrichtung (90) zurückgehalten werden, die unmittelbar stromabwärts des offenen Endes (21) der rohrartigen Spaltungskammer (20) angeordnet ist, und dadurch, dass das Zurückhalten der unerwünschten Atome des gespaltenen Vorproduktes durch chemische Reaktion zwischen den Atomen und der Filtervorrichtung (90) erhalten wird.

5. Verfahren nach einem der Ansprüche 1 bis 4, **dadurch gekennzeichnet, dass** es ferner vor, während oder nach den Schritten der thermochemischen Behandlung der Oberfläche durch Spalten des flüssigen oder Gasvorproduktes die Schritte enthält:
a') wenn nicht vorher ausgeführt, Verbinden der Anode (2) mit einer ersten Elektrode (2a) mit einer Erdung (2b) und Verbinden der Kathode (3) mit der Halterung (S), die als die andere Elektrode (3a) des Systems von Anode (2) und Kathode (3) arbeitet, und einem negativen Potenzial der pulsierenden Gleichstrom-Leistungsversorgung (10);
b') wenn nicht vorher ausgeführt, statisches Positionieren der metallischen Teile (1) auf er Halterung (S), die innerhalb der Reaktionskammer (RC) mit der Kathode (3) verbunden ist;
c') wenn nicht vorher ausgeführt, Umgeben der Halterung (S) und der metallischen Teile (1) mit einer Beladung aus ionisierbarem Gas, die der Reaktionskammer (RC) durch den Einlass (4) zugeführt wird;
d') wenn nicht vorher ausgeführt, Aufheizen des Inneren der Reaktionskammer (RC) auf eine Arbeitstemperatur ;
e') Anlegen einer elektrischen Entladung an die Kathode (3), die mit der Halterung (S) und den metallischen Teilen (1) verbunden ist, um die Bildung eines Gasplasmas von Ionen zu verursachen, die eine hohe kinetische Energie haben, das die metallischen Teile (1) und die Halterung (S) umgibt;
f') Bereitstellen eines festen Vorproduktes, das das Innere wenigstens einer rohrartigen Spaltungskammer (40) definiert, von der ein Ende zum Inneren der Reaktionskammer (RC) offen ist und die mit einer elektrischen Leistungsversorgung (50) verbunden ist;
g') Anlegen einer Potenzialdifferenz zwischen der wenigstens einen rohrartigen Spaltungskammer (40) und der Anode (2) des Systems von Anode (2) und Kathode (3), um das Spalten des festen Vorproduktes bereitzustellen, wodurch aus dem letzteren und ins Innere der Reaktionskammer (RC) die Legierungselemente freizugeben, die negativ polarisiert durch die pulsierende Gleichstrom-Leistungsversorgung (10) ionisch gegen die Oberflächen der metallischen Teile (1) geschleudert werden; und
h') Bereitstellen des Ausströmens der Gasbeladung aus dem Inneren der Reaktionskammer (RC).

6. Verfahren nach Anspruch 5, **dadurch gekennzeichnet, dass** die wenigstens eine rohrartige Spaltungskammer (40) der Arbeitstemperatur im Inneren der Reaktionskammer (RC) ausgesetzt ist.

7. Verfahren nach einem der Ansprüche 5 und 6, **dadurch gekennzeichnet, dass** die wenigstens eine rohrartige Spaltungskammer (40) eine hohle Kathode in Verbindung mit der Anode (2) des Systems von Anode (2) und Kathode (3) der Reaktionskammer (RC) des Reaktors (R) definiert.

8. Verfahren nach einem der Ansprüche 5 bis 7, **dadurch gekennzeichnet, dass** die Ionisierung der Gasbeladung und des festen Vorproduktes durch eine elektrische Gleichstrom-Entladung unter einer Atmosphäre mit niedrigem Druck ausgeführt wird, was ein Plasma generiert und die Legierungselemente für die Oberflächenbehandlung der metallischen Teile (1) erzeugt.

9. Reaktor zur thermochemischen Behandlung der Oberfläche von metallischen Teilen in einem Plasmareaktor (R), der ein metallisches Gehäuse (8) hat, das im Inneren eine Reaktionskammer (RC) definiert, die versehen ist mit: einer Halterung (S), die die metallischen Teile (1) trägt; einem System aus Anode (2) und Kathode (3), das mit einer pulsierenden Gleichstrom-Leistungsversorgung (10) verbunden ist; einem Einlass (4) für eine Beladung mit ionisierbarem Gas; einem Einlass (5) für flüssiges oder Gasvorprodukt; einem Auslass (6) zum Ausströmen von Gasbeladung, verbunden mit einem Vakuumsystem (7); und Heizeinrichtungen (60), die an dem metallischen Gehäuse (8) montiert sind, um das Innere der Reaktionskammer (RC) auf eine Arbeitstemperatur aufzuheizen, wobei der Reaktor enthält:
- die Anode (2) ist mit einer ersten Elektrode (2a) und mit einer Erdung (2b) verbunden und die Kathode (3) ist mit der Halterung (S), die als die andere Elektrode (3a) des Systems von Anode (2) und Kathode (3) arbeitet, und mit einem entsprechenden negativen Potenzial der pulsierenden Gleichstrom-Leistungsversorgung (10) verbunden;
- die Halterung (S) trägt die metallischen Teile (1) statisch und ist im Inneren der Reaktionskammer (RC) mit der Kathode (3) verbunden;
- wenigstens eine rohrartige Spaltungskammer (20) einer entsprechenden Strömung von flüssigem oder Gasvorprodukt, die darin zugelassen ist, mit wenigstens einem Ende (21) zum Inneren der Reaktionskammer (RC) hin offen und verbunden mit einer Hochspannungsenergiequelle (30) zum Dissoziieren der Moleküle des Vorproduktes und ihrer Freigabe ins Innere der Reaktionskammer (RC), wobei der Reaktor **dadurch gekennzeichnet ist, dass** die wenigstens eine rohrartige Spaltungskammer (20) im Inneren der Reaktionskammer (RC) oberhalb der Halterung (S) positioniert ist und der Arbeitstemperatur im Inneren der der Reaktionskammer (RC) ausgesetzt ist und die Strömung von flüssigem oder Gasvorprodukt mittels eines Zufuhrrohres (25) erhält, das von einer Quelle (PS1) von flüssigem oder Gasvorprodukt kommt, die außerhalb des Reaktors ist.

10. Reaktor nach Anspruch 9, **dadurch gekennzeichnet, dass** die wenigstens eine Spaltungskammer (20) eine hohle Kathode in Verbindung mit der Anode (2) des Systems von Anode (2) und Kathode (3) der Reaktionskammer (RC) des Reaktors (R) definiert.

11. Reaktor nach einem der Ansprüche 9 und 10, **dadurch gekennzeichnet, dass** die Erregung der wenigstens einen rohrartigen Spaltungskammer (20) durch das Zufuhrrohr (25) für flüssiges oder Gasvorprodukt selbst ausgeführt wird.

12. Reaktor nach einem der Ansprüche 9 bis 11, **dadurch gekennzeichnet, dass** er ferner enthält eine Filtervorrichtung (90), die unmittelbar stromabwärts des entsprechenden wenigstens einen offenen Endes (21) der rohrartigen Spaltungskammer (20) angeordnet ist und die in der Lage ist, mit eventuell unerwünschten Atomen chemisch zu reagieren, die von der rohrartigen Spaltungskammer (20) zusammen mit den erwünschten Atomen der Legierungselemente freigegeben werden, um ionisch gegen die Oberfläche der metallischen Teile (1) geschleudert zu werden, wobei die eventuell unerwünschten Atome in der Filtervorrichtung (90) zurückgehalten werden, und dadurch, dass die Filtervorrichtung (90) durch ein Rohr (91) definiert ist, das gebildet ist aus oder intern ausgekleidet ist mit einem Material, das mit den unerwünschten Atomen reagieren kann, und positioniert und befestigt ist benachbart zu und axial ausgerichtet mit dem offenen Ende (21) der rohrartigen Spaltungskammer (20).

13. Reaktor nach Anspruch 12, **dadurch gekennzeichnet, dass** die Filtervorrichtung (90) durch eine rohrartige Verlängerung der rohrartigen Spaltungskammer (20) selbst definiert ist.

14. Reaktor nach einem der Ansprüche 9 bis 13, **dadurch gekennzeichnet, dass** er ferner enthält:
- wenigstens eine rohrartige Aufdampfkammer (40), die das feste Vorprodukt trägt, mit einem Ende (41) offen zum Inneren der Reaktionskammer (RC) und verbunden mit einer elektrischen Leistungsversorgung (50), um das Aufdampfen des festen Vorprodukts und das Freigeben seiner Legierungselemente bereitzustellen, die ionisch gegen die metallischen Teile (1) geschleudert werden, die durch die pulsierende Gleichstrom-Leistungsversorgung (10) negativ polarisiert sind.

15. Reaktor nach Anspruch 14, **dadurch gekennzeichnet, dass** die wenigstens eine rohrartige Aufdampfkammer (40) im Inneren der Reaktionskammer (RC) oberhalb der Halterung (S) angeordnet ist und der Arbeitstemperatur des Inneren der Reaktionskammer (RC) ausgesetzt ist.

16. Reaktor nach Anspruch 15, **dadurch gekennzeichnet, dass** die wenigstens eine rohrartige Aufdampfkammer (40) eine hohle Kathode in Verbindung mit der Anode (2) des Systems aus Anode (2) und Kathode (3) der Reaktionskammer (RC) des Reaktors (R) definiert.

17. Reaktor nach Anspruch 16, **dadurch gekennzeichnet, dass** das feste Vorprodukt durch die entsprechende rohrartige Aufdampfkammer (40) definiert ist.

## Revendications

1. Un procédé de traitement thermochimique de la surface de pièces métalliques, dans un réacteur à plasma (R) comportant une chambre de réaction (RC) munie : d'un support (S) portant les pièces métalliques (1) ; d'un système d'anode (2) et de cathode (3) ayant l'une de ses électrodes (2a, 3a) associée à une alimentation en courant continu pulsé (10) ; d'une entrée (4) de charge de gaz ionisable ; d'une entrée de précurseur (5) liquide ou gazeux ; et d'une sortie (6) pour l'évacuation de la charge de gaz, comprenant les étapes consistant à:
a) connecter l'anode (2) à une première électrode (2a) et à une masse (2b) et connecter la cathode (3) au support (S), agissant en tant que l'autre électrode (3a) du système d'anode (2) et de cathode (3), et à un potentiel négatif de l'alimentation en courant continu pulsé (10) ;
b) positionner de manière stable les pièces métalliques (1) sur le support (S)associé à la cathode (3) à l'intérieur de la chambre de réaction (RC) ;
c) noyer le support (S) et les pièces métalliques (1) d'une charge de gaz ionisable alimentée dans la chambre de réaction (RC) via l'entrée (4) ;
d) chauffer l'intérieur de la chambre de réaction (RC) à une température de travail ;
e) appliquer sur la cathode (3), associée au support (S) et aux pièces métalliques (1), une décharge électrique afin de provoquer la formation d'un plasma d'ions gazeux à haute énergie cinétique noyant les pièces métalliques (1) et le support (S) ;
f) envoyer un flux de précurseur liquide ou gazeux dans au moins une chambre de craquage tubulaire (20) ayant au moins une extrémité (21) ouverte vers l'intérieur de la chambre de réaction (RC) et étant associée à une source d'énergie haute tension (30) ;
g) appliquer une différence de potentiel entre la au moins une chambre de craquage tubulaire (20) et l'anode (2) du système d'anode (2) et de cathode (3) afin de dissocier les molécules du précurseur admis dans ladite chambre de craquage tubulaire (20), libérant, vers l'intérieur de la chambre de réaction (RC), les atomes des éléments d'alliage à bombarder par voie ionique contre les surfaces des pièces métalliques (1) polarisées négativement par l'alimentation à courant continu pulsé (10) ; et
h) réaliser l'évacuation de la charge de gaz hors de l'intérieur de la chambre de réaction (RC),
le procédé étant **caractérisé en ce que** la chambre de craquage tubulaire (20) est soumise à la température de travail régnant à l'intérieur de la chambre de réaction (RC).

2. Le procédé selon la revendication 1, **caractérisé en ce que** la chambre de craquage tubulaire (20) définit une cathode creuse en association avec l'anode (2) du système d'anode (2) et de cathode (3) de la chambre de réaction (RC) du réacteur (R).

3. Le procédé selon l'une des revendications 1 et 2, **caractérisé en ce que** la charge de gaz ionisable comprend en outre l'addition d'un gaz choisi parmi l'oxygène, l'hydrogène, l'azote et l'argon pour réagir avec les atomes ou les molécules obtenus par craquage du précurseur liquide, formant ainsi des composés dirigés sur les pièces métalliques (1) avec une énergie cinétique résultant de l'accélération provoquée par la différence de potentiel appliquée au système d'anode (2) et de cathode (3).

4. Le procédé selon l'une des revendications 1 à 3, **caractérisé en ce que** le précurseur craqué, libéré de la chambre de craquage tubulaire (20) et pour avoir les atomes souhaitables des éléments d'alliage bombardés de manière ionique contre la surface des pièces métalliques (1), a éventuellement des atomes indésirables retenus dans un dispositif de filtrage (90) situé immédiatement en aval de ladite extrémité ouverte (21) de la chambre de craquage tubulaire (20) et **en ce que** la rétention d'atomes indésirables du précurseur craqué est obtenue par réaction chimique entre lesdits atomes et le dispositif de filtrage (90).

5. Le procédé selon l'une des revendications 1 à 4, **caractérisé en ce qu'**il comprend en outre, avant, pendant ou après les étapes de traitement de surface thermochimique par craquage du précurseur liquide ou gazeux, les étapes suivantes :
a') si cela n'a pas déjà été fait, relier l'anode (2) à une première électrode (2a) et à une masse (2b), et relier la cathode (3) au support (S), agissant comme l'autre électrode (3a) du système d'anode (2) et de cathode (3), et à un potentiel négatif de l'alimentation en courant continu pulsé (10) ;
b') si cela n'a pas déjà été fait, positionner de façon stable les pièces métalliques (1) sur le support (S) associé à la cathode (3) à l'intérieur de la chambre de réaction (RC) ;
c') si cela n'a pas déjà été fait, noyer le support (S) et les pièces métalliques (1) avec une charge de gaz ionisable introduite dans la chambre de réaction (RC) via l'entrée (4) ;
d') si cela n'a pas déjà été fait, chauffer l'intérieur de la chambre de réaction (RC) à une température de travail ;
e') appliquer sur la cathode (3), associée au support (S) et aux pièces métalliques (1), une décharge électrique afin de provoquer la formation d'un plasma ionique gazeux, ayant une haute énergie cinétique, noyant les pièces métalliques (1) et le support (S) ;
f') fournir un précurseur solide définissant l'intérieur d'au moins une chambre de pulvérisation tubulaire (40), ayant une extrémité ouverte sur la chambre de réaction intérieure (RC) et étant associée à une alimentation électrique (50) ;
g') appliquer une différence de potentiel entre la au moins une chambre de pulvérisation tubulaire (40) et l'anode (2) du système d'anode (2) et de cathode (3) afin d'assurer la pulvérisation du précurseur solide, en libérant, de ce dernier et à l'intérieur de la chambre de réaction (RC), les éléments d'alliage à bombarder de façon ionique contre les surfaces des pièces métalliques (1) polarisées négativement par l'alimentation en courant continu pulsé (10) ; et
h') réaliser l'évacuation de la charge de gaz provenant de l'intérieur de la chambre de réaction (RC).

6. Le procédé selon la revendication 5, **caractérisé en ce que** la au moins une chambre de pulvérisation tubulaire (40) est soumise à la température de travail régnant à l'intérieur de la chambre de réaction (RC).

7. Le procédé selon l'une des revendications 5 et 6, **caractérisé en ce que** la au moins une chambre de pulvérisation tubulaire (40) définit une cathode creuse associée à l'anode (2) du système d'anode (2) et de cathode (3) de la chambre de réaction (RC) du réacteur (R).

8. Le procédé selon l'une des revendications 5 à 7, **caractérisé en ce que** l'ionisation de la charge de gaz et du précurseur solide est réalisée par une décharge électrique de courant continu sous atmosphère à basse pression, générant un plasma et produisant les éléments d'alliage pour le traitement de surface des pièces métalliques (1).

9. Un réacteur pour le traitement thermochimique de la surface de pièces métalliques, ledit réacteur à plasma (R) comportant un boîtier métallique (8) définissant, intérieurement, une chambre de réaction (RC) munie : d'un support (S) portant les pièces métalliques (1) ; d'un système d'anode (2) et de cathode (3) associé à une alimentation (10) en courant continu puisé ; d'une entrée (4) de charge de gaz ionisable ; d'une entrée (5) de précurseur liquide ou gazeux ; d'une sortie (6) d'évacuation de la charge de gaz, reliée à un système pour faire le vide (7) ; et de moyens de chauffage (60) montés sur le boîtier métallique (8) afin de chauffer l'intérieur de la chambre de réaction (RC) à une température de travail, le réacteur comprenant :
- l'anode (2) connectée à une première électrode (2a) et à une masse (2b), et la cathode (3) connectée au support (S), agissant comme l'autre électrode (3a) du système d'anode (2) et de cathode (3), et à un potentiel négatif respectif de l'alimentation en courant continu pulsé (10) ;
- le support (S) portant, de façon stable, les pièces métalliques (1) et étant associé à la cathode (3) à l'intérieur de la chambre de réaction (RC) ;
- au moins une chambre de craquage tubulaire (20) d'un flux respectif de précurseur liquide ou gazeux qui doit être admis dans celle-ci, ayant au moins une extrémité (21) ouverte vers l'intérieur de la chambre de réaction (RC) et étant associée à une source d'énergie haute tension (30) pour dissocier les molécules du précurseur et leur libération à l'intérieur de la chambre de réaction (RC), le réacteur étant **caractérisé en ce que** la au moins une chambre de craquage tubulaire (20) est positionnée à l'intérieur de la chambre de réaction (RC), au-dessus du support (S) et est soumise à la température de travail régnant à l'intérieur de la chambre de réaction (RC) et reçoit le flux de précurseur liquide ou gazeux au moyen d'un tube d'alimentation (25) provenant d'une source (PS1) de précurseur liquide ou gazeux, extérieur au réacteur.

10. Le réacteur selon la revendication 9, **caractérisé en ce que** la au moins une chambre de craquage tubulaire (20) définit une cathode creuse en association avec l'anode (2) du système d'anode (2) et de cathode (3) de la chambre de réaction (RC) du réacteur (R).

11. Le réacteur selon l'une des revendications 9 et 10, **caractérisé en ce que** la mise sous tension de la au moins une chambre de craquage tubulaire (20) est réalisée par le tube d'alimentation (25) lui-même en précurseur liquide ou gazeux.

12. Le réacteur selon l'une des revendications 9 à 11, **caractérisé en ce qu'**il comprend en outre un dispositif de filtration (90) situé immédiatement en aval de la au moins une extrémité ouverte (21) de la chambre de craquage tubulaire (20) et qui est apte de réagir chimiquement avec d'éventuels atomes indésirables libérés par la chambre de craquage tubulaire (20) en même temps que les atomes souhaitables d'éléments d'alliage devant être bombardés de manière ionique contre la surface des pièces métalliques (1), lesdits éventuels atomes indésirables étant retenus dans le dispositif de filtration (90), et **en ce que** le dispositif de filtration (90) est défini par un tube (91) construit ou revêtu intérieurement d'un matériau susceptible de réagir avec lesdits atomes indésirables, et est positionné et fixé de manière adjacente à ladite extrémité ouverte (21) de la chambre de craquage tubulaire (20), et aligné axialement avec cette extrémité ouverte.

13. Le réacteur selon la revendication 12, **caractérisé en ce que** le dispositif de filtrage (90) est défini par une extension tubulaire de la chambre de craquage tubulaire (20) elle-même.

14. Le réacteur selon l'une des revendications 9 à 13, **caractérisé en ce qu'**il comprend en outre :
- au moins une chambre de pulvérisation tubulaire (40) portant le précurseur solide, ayant une extrémité (41) ouverte vers l'intérieur de la chambre de réaction (RC) et étant associée à une alimentation en énergie électrique (50) pour assurer la pulvérisation du précurseur solide et la libération de ses éléments d'alliage bombardés de façon ionique contre les pièces métalliques (1) polarisées négativement par l'alimentation continue pulsée (10).

15. Le réacteur selon la revendication 14, **caractérisé en ce que** la au moins une chambre de pulvérisation tubulaire (40) est positionnée à l'intérieur de la chambre de réaction (RC), au-dessus du support (S) et est soumise à la température de travail régnant à l'intérieur de la chambre de réaction (RC).

16. Le réacteur selon la revendication 15, **caractérisé en ce que** la au moins une chambre de pulvérisation tubulaire (40) définit une cathode creuse en association avec l'anode (2) du système d'anode (2) et de cathode (3) de la chambre de réaction (RC) du réacteur (R).

17. Le réacteur selon la revendication 16, **caractérisé en ce que** le précurseur solide est défini par la chambre de pulvérisation tubulaire respective (40).
